# EUROPEAN PATENT APPLICATION

(11) **EP 4 626 162 A1**
(43) Date of publication of application: **01.10.2025**
(21) Application number: 24905102.0
(22) Date of filing: 09.12.2024
(51) Int. Cl.: H05K 7/20

(54) **ELECTRIC TOOL**

(30) Priority: 20.12.2023 CN 202311767477
(71) Applicant: Nanjing Chervon Industry Co., Ltd., Nanjing, Jiangsu 211106 (CN)
(72) Inventor: FENG, Jifeng, Nanjing, Jiangsu 211106 (CN); LI, Haiyan, Nanjing, Jiangsu 211106 (CN)
(74) Representative: Sun, Yiming
(86) International application number: PCT/CN2024/137771
(87) International publication number: WO 2025/130679

(57) **Abstract**

A power tool includes: a working assembly configured to perform work of the power tool; a drive assembly including an electric motor and configured to drive the working assembly; a power supply assembly configured to supply power to the drive assembly; and a control assembly at least configured to control running of the electric motor. The control assembly includes a first circuit board and at least one heat dissipation element. At least one power element is included on the first circuit board. Each heat dissipation element includes: a main body configured to be in thermal contact with a surface of a power element; and a first connection portion connected to the main body and electrically connected to the first circuit board.

## Description

This application claims priority to Chinese Patent Application No. 202311767477.8 filed with the China National Intellectual Property Administration (CNIPA) on Dec. 20, 2023, the disclosure of which is incorporated herein by reference in its entirety.

### TECHNICAL FIELD

The present application relates to the technical field of tools, for example, a power tool.

### BACKGROUND

Power tools are more environmentally friendly than engine-powered tools and thus are widely applied. A power tool is generally driven to work by an electric motor. The power tool is provided with a circuit board for controlling the electric motor. Multiple metal-oxide-semiconductor field-effect transistors (MOSFETs) are disposed on the circuit board, and the electric motor is electrically connected to the circuit board through a motor wire.

When the power tool works and runs, the circuit board generates heat. Specifically, the MOSFETs on the circuit board and the electrical connection of the motor wire generate heat. When the working current of the power tool is relatively large, the MOSFETs on the circuit board generate more heat, and the temperatures of the MOSFETs are higher. If the heat dissipation effect on the MOSFETs is poor, the MOSFETs are caused to constantly maintain relatively high temperatures. As a result, the circuit board and the power tool fail to work and run normally.

This part provides background information related to the present application, and the background information is not necessarily the existing art.

### SUMMARY

The present application provides a power tool with excellent heat dissipation performance.

To achieve the preceding object, the present application adopts the technical solutions below.

A power tool includes: a working assembly configured to perform work of the power tool; a drive assembly including an electric motor and configured to drive the working assembly; a power supply assembly configured to supply power to the drive assembly; and a control assembly at least configured to control running of the electric motor. The control assembly includes a first circuit board and at least one heat dissipation element. At least one power element is included on the first circuit board. Each heat dissipation element includes: a main body configured to be in thermal contact with a surface of a power element; and a first connection portion connected to the main body and electrically connected to the first circuit board.

In some examples, the heat dissipation element further includes a second connection portion, a first end of the second connection portion is connected to the main body, and a second end of the second connection portion is configured to be connected to a motor wire of the electric motor.

In some examples, the second connection portion extends outward along a direction opposite to the first connection portion.

In some examples, at least part of the first connection portion is located below the main body, and at least part of the second connection portion is located above the main body.

In some examples, the main body is located on the power element and is in thermal contact with the surface of the power element through a thermally conductive adhesive.

In some examples, the control assembly further includes a second circuit board, and the second circuit board is located on the heat dissipation element and in contact with the main body.

In some examples, the heat dissipation element further includes a second connection portion, the control assembly further includes a second circuit board, and the second connection portion is located on a side of the second circuit board.

In some examples, the control assembly further includes a heat dissipation case, one surface of the heat dissipation case is in contact with the first circuit board, and multiple heat dissipation fins are provided on another surface of the heat dissipation case.

In some examples, the heat dissipation element is made of copper.

In some examples, the power element is a MOSFET.

In some examples, the power tool includes multiple power elements, every preset number of power elements are defined as one power element group, the number of heat dissipation elements is equal to the number of power element groups, and each heat dissipation element corresponds to one power element group.

In some examples, each heat dissipation element is electrically connected at the central position of corresponding one power element group.

In some examples, the first connection portion is a plane with an area of greater than or equal to 25 mm².

In some examples, power of the power tool is greater than or equal to 1200 W.

In some examples, a working current of the power tool is greater than or equal to 20 A.

In some examples, a power tool includes: a working assembly configured to perform work of the power tool; a drive assembly including an electric motor and configured to drive the working assembly; a power supply assembly configured to supply power to the drive assembly; and a control assembly at least configured to control running of the electric motor. The control assembly includes: a first circuit board, at least one heat dissipation element, and a heat dissipation case. One surface of the first circuit board is electrically connected to the at least one heat dissipation element, and the other surface of the first circuit board is in contact with the heat dissipation case.

In some examples, at least one power element is included on the first circuit board, each of the at least one heat dissipation element includes a first connection portion and a main body, and the main body is in thermal contact with a surface of a power element when the first connection portion is electrically connected to the first circuit board.

In some examples, the heat dissipation element further includes a second connection portion, a first end of the second connection portion is connected to the main body, and a second end of the second connection portion is configured to be connected to a motor wire of the electric motor.

In some examples, a power tool includes: a working assembly configured to perform work of the power tool; a drive assembly including an electric motor and configured to drive the working assembly; a power supply assembly configured to supply power to the drive assembly; and a control assembly at least configured to control running of the electric motor. The control assembly includes a first circuit board and at least one heat dissipation element. Each of the at least one heat dissipation element includes a first connection portion, a main body, and a second connection portion, and the first connection portion and the second connection portion are each connected to the main body. The first connection portion is configured to be electrically connected to the first circuit board, and the second connection portion is configured to be connected to a motor wire of the electric motor. The first connection portion and the second connection portion extend in opposite directions along a direction perpendicular to the main body.

In some examples, at least one power element is included on the first circuit board, and the main body is in thermal contact with a surface of a power element.

In the present application, the heat dissipation element is in thermal contact with the surface of the power element, allowing the heat dissipation element to dissipate heat from the power element. Thus, the heat dissipation effect of the heat dissipation element is enhanced, thereby further improving the heat dissipation performance of the power tool.

### BRIEF DESCRIPTION OF DRAWINGS

FIG. 1 is a perspective view of a backpack blower according to an example;
FIG. 2 is a rear view of the backpack blower in FIG. 1;
FIG. 3 is a perspective view showing the connection between an electric motor and a control assembly in FIG. 1;
FIG. 4 is a perspective view of a control assembly according to an example;
FIG. 5 is a three-dimensional exploded view of the control assembly in FIG. 4;
FIG. 6 is a perspective view of a control assembly according to an example;
FIG. 7 is a front view of a heat dissipation element of the control assembly in FIG. 4;
FIG. 8 is a top view of the control assembly in FIG. 4;
FIG. 9 is a front view of the control assembly in FIG. 4;
FIG. 10 is a three-dimensional exploded view of a control assembly according to an example; and
FIG. 11 is a three-dimensional exploded view of a control assembly according to an example.

### DETAILED DESCRIPTION

Before any examples of this application are explained in detail, it is to be understood that this application is not limited to its application to the structural details and the arrangement of components set forth in the following description or illustrated in the above drawings.

In this application, the terms "comprising", "including", "having" or any other variation thereof are intended to cover an inclusive inclusion such that a process, method, article or device comprising a series of elements includes not only those series of elements, but also other elements not expressly listed, or elements inherent in the process, method, article, or device. Without further limitations, an element defined by the phrase "comprising a ..." does not preclude the presence of additional identical elements in the process, method, article, or device comprising that element.

In this application, the term "and/or" is a kind of association relationship describing the relationship between associated objects, which means that there can be three kinds of relationships. For example, A and/or B can indicate that A exists alone, A and B exist simultaneously, and B exists alone. In addition, the character "/" in this application generally indicates that the contextual associated objects belong to an "and/or" relationship.

In this application, the terms "connection", "combination", "coupling" and "installation" may be direct connection, combination, coupling or installation, and may also be indirect connection, combination, coupling or installation. Among them, for example, direct connection means that two members or assemblies are connected together without intermediaries, and indirect connection means that two members or assemblies are respectively connected with at least one intermediate members and the two members or assemblies are connected by the at least one intermediate members. In addition, "connection" and "coupling" are not limited to physical or mechanical connections or couplings, and may include electrical connections or couplings.

In this application, it is to be understood by those skilled in the art that a relative term (such as "about", "approximately", and "substantially") used in conjunction with quantity or condition includes a stated value and has a meaning dictated by the context. For example, the relative term includes at least a degree of error associated with the measurement of a particular value, a tolerance caused by manufacturing, assembly, and use associated with the particular value, and the like. Such relative term should also be considered as disclosing the range defined by the absolute values of the two endpoints. The relative term may refer to plus or minus of a certain percentage (such as 1%, 5%, 10%, or more) of an indicated value. A value that did not use the relative term should also be disclosed as a particular value with a tolerance. In addition, "substantially" when expressing a relative angular position relationship (for example, substantially parallel, substantially perpendicular), may refer to adding or subtracting a certain degree (such as 1 degree, 5 degrees, 10 degrees or more) to the indicated angle.

In this application, those skilled in the art will understand that a function performed by an assembly may be performed by one assembly, multiple assemblies, one member, or multiple members. Likewise, a function performed by a member may be performed by one member, an assembly, or a combination of members.

In this application, the terms "up", "down", "left", "right", "front", and "rear" and other directional words are described based on the orientation or positional relationship shown in the drawings, and should not be understood as limitations to the examples of this application. In addition, in this context, it also needs to be understood that when it is mentioned that an element is connected "above" or "under" another element, it can not only be directly connected "above" or "under" the other element, but can also be indirectly connected "above" or "under" the other element through an intermediate element. It should also be understood that orientation words such as upper side, lower side, left side, right side, front side, and rear side do not only represent perfect orientations, but can also be understood as lateral orientations. For example, lower side may include directly below, bottom left, bottom right, front bottom, and rear bottom.

In this application, the terms "controller", "processor", "central processor", "CPU" and "MCU" are interchangeable. Where a unit "controller", "processor", "central processing", "CPU", or "MCU" is used to perform a specific function, the specific function may be implemented by a single aforementioned unit or a plurality of the aforementioned unit.

In this application, the term "device", "module" or "unit" may be implemented in the form of hardware or software to achieve specific functions.

In this application, the terms "computing", "judging", "controlling", "determining", "recognizing" and the like refer to the operations and processes of a computer system or similar electronic computing device (e.g., controller, processor, etc.).

Power tools to which technical solutions of the present application are applicable include handheld power tools, fastening power tools, cutting power tools, and sanding power tools. For example, the power tools include a blower, an electric drill, an electric circular saw, a reciprocating saw, an impact wrench, an impact screwdriver, and a hammer anvil. Other types of power tools which can adopt the substance of the technical solutions disclosed below may fall within the scope of the present application.

A power tool is generally driven to work by an electric motor. The power tool is provided with a circuit board for controlling the electric motor. The circuit board includes both a power aluminum substrate and a control board. The power aluminum substrate and the control board may be disposed on the same layer or may be disposed on two layers, that is, the control board may be located above the power aluminum substrate. To reduce the volume of the space occupied by the two circuit boards, the control board is typically disposed above the power aluminum substrate. The power aluminum substrate includes multiple MOSFETs for controlling running of the electric motor, and a motor wire of the electric motor is typically electrically connected to the middle of the power aluminum substrate. When the motor wire is routed outward, the motor wire needs to pass through the control board. To ensure a function of the control board, it is necessary to enlarge the size of the control board. As a result, the overall volume of the circuit board is increased. In addition, heat is generated at the electrical connection between the motor wire and the power aluminum substrate, and the MOSFETs also generate heat. When the working current or working power of the power tool is relatively large, the MOSFETs generate more heat. If the heat of the MOSFETs and the heat of the electrical connection between the motor wire and the power aluminum substrate are insufficiently dissipated, the power tool may fail to work normally. Based on this, the present application provides a power tool with excellent heat dissipation performance.

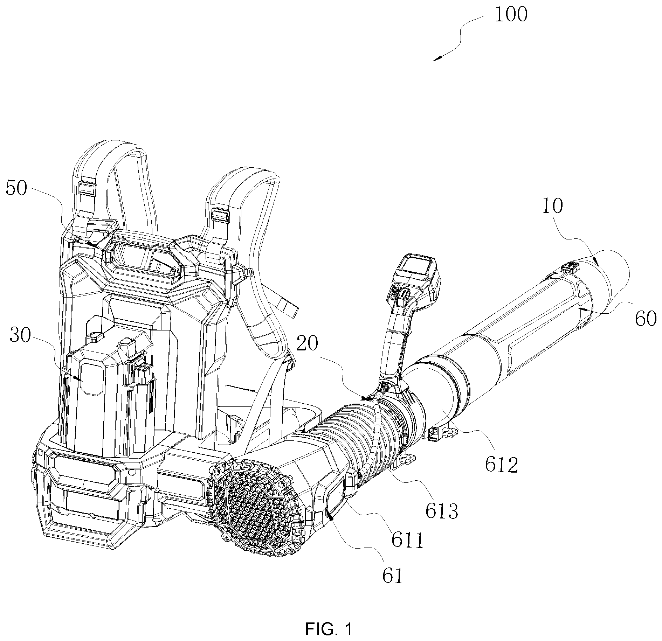

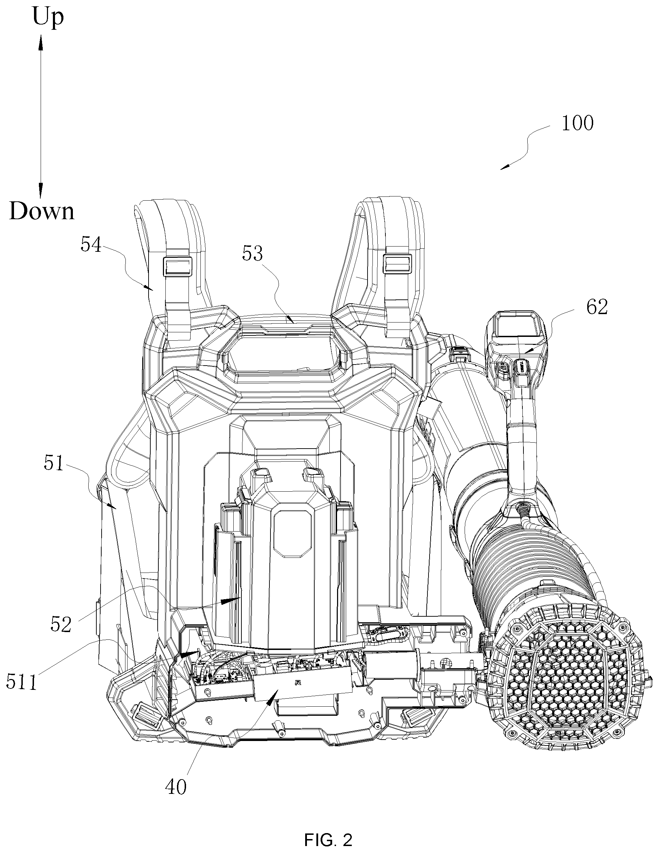

As shown in FIGS. 1 and 2, the present application provides a power tool 100. The power tool 100 achieves corresponding functions of the tool through its functional elements. In this example, a backpack blower is used as an example of the power tool 100. The backpack blower is configured to be operated by a user to clear fallen leaves from the ground.

In other examples, it is to be understood that the power tool 100 may be a handheld power tool, for example, a drill, a pruner, or a sander. Alternatively, the power tool 100 may be a table tool, such as a table saw or a miter saw. Alternatively, the power tool 100 may be a hand-push power tool, for example, a hand-push mower or a hand-push snow thrower. Alternatively, the power tool 100 may be a riding power tool, for example, a riding mower, a riding vehicle, or an all-terrain vehicle. Alternatively, the power tool 100 may be a robotic tool, such as a robotic mower or a robotic snow thrower.

In some examples, the power tool 100 may be a garden tool, such as a pruner, a mower, or a chainsaw. Alternatively, the power tool 100 may be a decorating tool, such as a screwdriver, a nail gun, a circular saw, or a sander.

In some examples, the power tool 100 may be a vegetation care tool, such as a string trimmer, a mower, a pruner, or a chainsaw. Alternatively, the power tool 100 may be a cleaning tool, such as a blower, a snow thrower, or a cleaning machine. Alternatively, the power tool 100 may be a drilling tool, such as a drill, a screwdriver, a wrench, or an electric hammer. Alternatively, the power tool 100 may be a sawing tool, such as a reciprocating saw, a jigsaw, or a circular saw. Alternatively, the power tool 100 may be a table tool, such as a table saw, a miter saw, a metal cutter, or an electric router. Alternatively, the power tool 100 may be a sanding tool, for example, an angle grinder or a sander. Alternatively, the power tool 100 may be another tool, for example, a lamp or a fan.

The power tool 100 includes a working assembly 10 configured to perform work of the power tool 100. In this example, the work of the power tool 100 is blowing. However, the working assembly 10 may be configured to perform other work of the power tool 100, such as weeding or cutting. A drive assembly 20 is configured to drive running of the working assembly 10, where the drive assembly 20 includes an electric motor. A power supply assembly 30 is configured to supply power to the drive assembly 20. A control assembly 40 is configured to control running of the electric motor. The power supply assembly 30 may be a battery pack or an alternating current power supply, that is, utility power of 120 V or 220 V may be connected through a power interface.

As shown in FIGS. 1 and 2, the power tool 100 includes a backpack main body 50 and a blower assembly 60 connected to the backpack main body 50. The blower assembly 60 includes the working assembly 10 and the drive assembly 20. The backpack main body 50 is configured to be carried by the user on the back. The blower assembly 60 is configured to generate airflow and guide the airflow. The backpack main body 50 includes a housing 51, and a battery pack 52 is detachably disposed on the housing 51, wherein the battery pack 52 is the power supply assembly 30. A carrying handle 53 is formed at the upper end of the housing 51 to facilitate carrying of the housing 51. Straps 54 are connected to the outside of the housing 51. One end of each of the straps 54 is connected to the carrying handle 53, and the other end of each of the straps 54 is connected to the housing 51 through a snap. The straps 54 are configured to encircle the user's body to allow the user to carry the backpack main body 50 on the shoulders.

The blower assembly 60 includes a duct 61. The duct 61 is disposed on one side of the housing 51. The duct 61 includes an intake duct 611, an exhaust duct 612, and a flexible duct 613. An air inlet is formed at one end of the intake duct 611, and an air outlet is formed at one end of the exhaust duct 612. The flexible duct 613 connects the intake duct 611 to the exhaust duct 612. Both the air inlet and the air outlet communicate with the outside. An operation handle 62 is disposed on the outer side of the duct 61 between the air inlet and the air outlet. The user can operate the blower assembly 60 through the operation handle 62. Specifically, the operation handle 62 is connected to the exhaust duct 612. The user may operate the operation handle 62 with one hand and swing the operation handle 62 to drive the exhaust duct 612 so as to adjust a direction of airflow flowing out from the exhaust duct 612. A shock absorber is disposed between the operation handle 62 and the exhaust duct 612. The shock absorber can reduce the shock transmitted from the exhaust duct 612 to the operation handle 62 and cushion the force transmitted between the operation handle 62 and the exhaust duct 612.

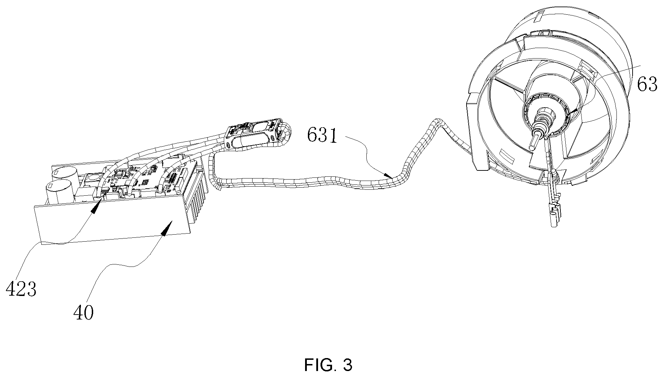

As shown in FIGS. 2 and 3, the blower assembly 60 further includes an electric motor 63 and a fan. The fan is disposed inside the duct 61 and is driven by the electric motor 63 to rotate around a pivot axis to generate airflow. The duct is configured to guide the airflow generated by the fan so that external air enters through the air inlet and exits through the air outlet. With the rotation of the fan, an airflow channel is formed inside the duct. The air inlet and the air outlet are located at two ends of the airflow channel, respectively, and a negative pressure zone is formed between the air inlet and the air outlet. The start and stop of the electric motor 63 can be controlled through the operation handle 62. As shown in FIG. 3, the electric motor 63 includes multiple motor wires 631 connected to the control assembly 40. As shown in FIG. 3, three motor wires 631 may be provided.

The backpack main body 50 and the blower assembly 60 are connected to each other through a connection assembly. Specifically, the connection assembly connects the housing 51 of the backpack main body 50 to the intake duct 611 of the blower assembly 60. The intake duct 611 is configured to be rotatable relative to the housing 51 to facilitate the adjustment of the direction of airflow flowing out from the exhaust duct 612.

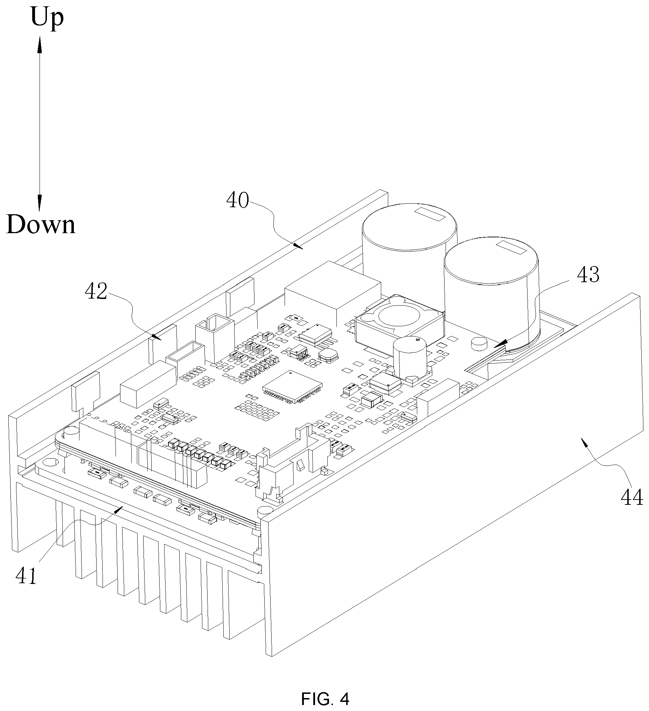

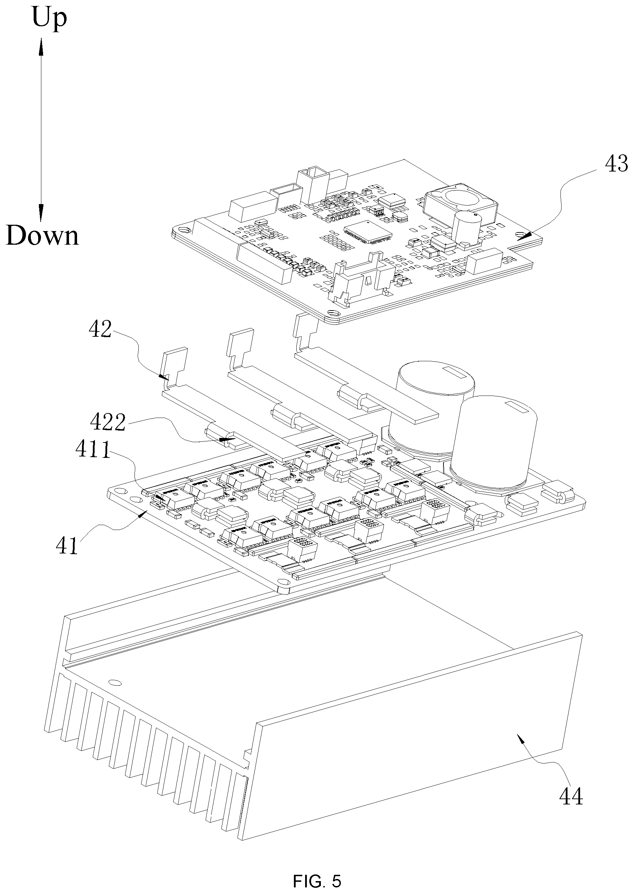

As shown in FIG. 2, an accommodation space 511 is formed in the housing 51. The accommodation space 511 is located below the battery pack 52. The control assembly 40 is disposed in the accommodation space 511. As shown in FIG. 4, the control assembly 40 is constituted by a first circuit board 41, heat dissipation elements 42, a second circuit board 43, and a heat dissipation case 44. The first circuit board 41, the heat dissipation elements 42, and the second circuit board 43 are all located in the heat dissipation case 44. As shown in FIG. 5, the second circuit board 43, the heat dissipation elements 42, and the first circuit board 41 are sequentially arranged from top to bottom.

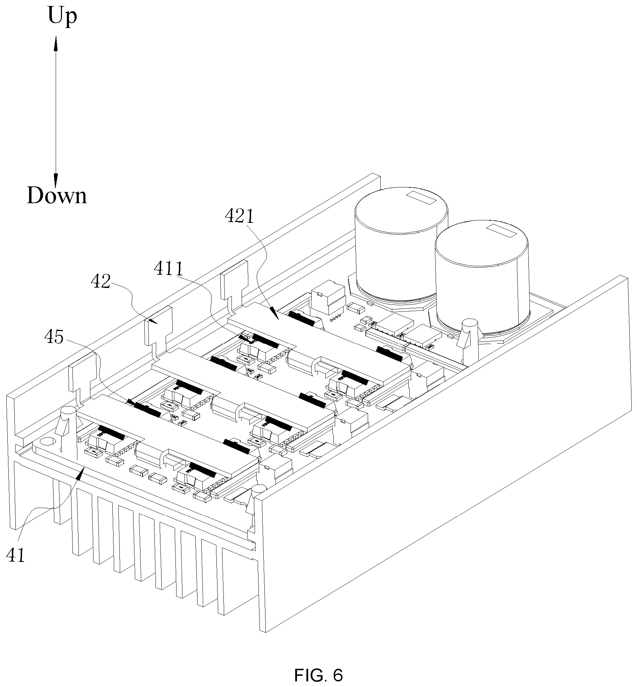

In some examples, the control assembly 40 includes the first circuit board 41 and at least one heat dissipation element 42, and at least one power element 411 is included on the first circuit board 41. Multiple power elements 411 may be disposed on the first circuit board 41. A preset number of power elements 411 are defined as a power element group. The number of heat dissipation elements 42 is the same as the number of power element groups. Each heat dissipation element 42 corresponds to one power element group such that each heat dissipation element 42 can dissipate heat from the corresponding power element group. The preset number of power elements 411 may be, for example, four as shown in FIG. 5. Alternatively, a different preset number of power elements 411 form one power element group. For example, two power elements 411 form one power element group. The preset number of power elements 411 in one power element group is not limited in the present application. The first circuit board 41 may be a power aluminum substrate, and the heat dissipation element 42 may be a copper element, for example, a copper strip. The power element 411 is a MOSFET and is configured to control work of the electric motor 63. As shown in FIGS. 5 and 6, the number of heat dissipation elements 42 and the number of power element groups may both be three or another number, which are not limited in the present application

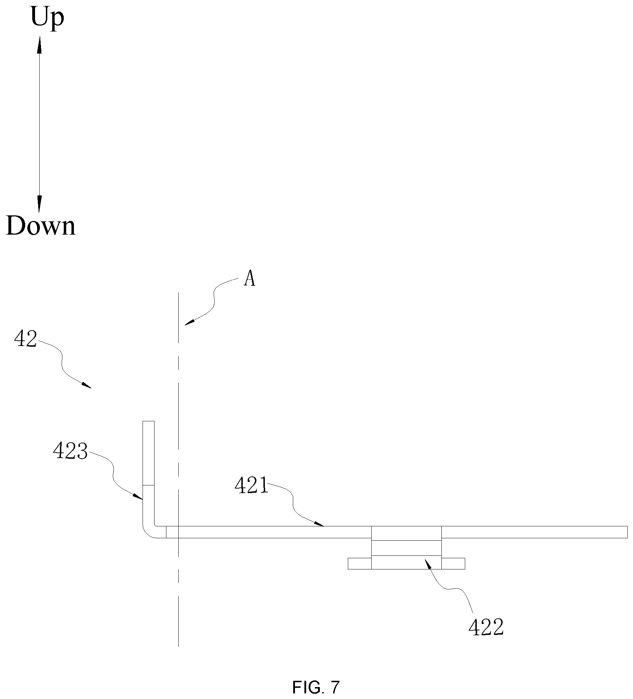

As shown in FIG. 7, the heat dissipation element 42 includes a main body 421 and a first connection portion 422. The main body 421 may be in thermal contact with a surface of the power element 411. The first connection portion 422 is connected to the main body 421 and may be electrically connected to the first circuit board 41. The electrical conductivity of the first connection portion 422 is 50*10^6 to 60*10^6 (S/m). The length of the main body 421 is greater than or equal to 24 mm, and the width of the main body 421 is greater than or equal to 8 mm. Specifically, as shown in FIGS. 5 and 6, the heat dissipation elements 42 are located on the first circuit board 41. The lower surface of the main body 421 covers the surface of the power element 411 and is in thermal contact with the surface of the power element 411. At least part of the first connection portion 422 is located below the main body 421 and opposite to the lower surface of the main body 421. Optionally, the main body 421 may be in thermal contact with the surface of the power element 411 through a thermally conductive adhesive 45. Thus, the heat generated by the power element 411 can be transferred to the heat dissipation element 42 through the thermally conductive adhesive 45 and then dissipated through the main body 421 of the heat dissipation element 42. The thermal conductivity of the heat dissipation element 42 is 200 to 400 W/(m·K). Since the heat dissipation element 42 is the copper strip, the heat can be dissipated through both the upper and lower surfaces of the copper strip simultaneously, thereby enhancing the heat dissipation effect on the power element 411. In addition, a thermally conductive element between the power element 411 and the heat dissipation element 42 may be another element having the function of conducting heat other than the thermally conductive adhesive 45, which is not limited in the present application. In this example, the heat dissipation element 42 is electrically connected to the first circuit board 41 and simultaneously dissipates the heat from the first circuit board 41, thereby effectively utilizing both the heat dissipation function of the heat dissipation element 42 and the electrical conduction function of the heat dissipation element 42. Moreover, the first connection portion 422 that is electrically connected to the first circuit board 41 and the main body 421 that dissipates the heat from the power element 411 are different portions of the heat dissipation element 42. Thus, the heat transfer path between the main body 421 and the power element 411 can be shortened, thereby further improving the heat dissipation effect.

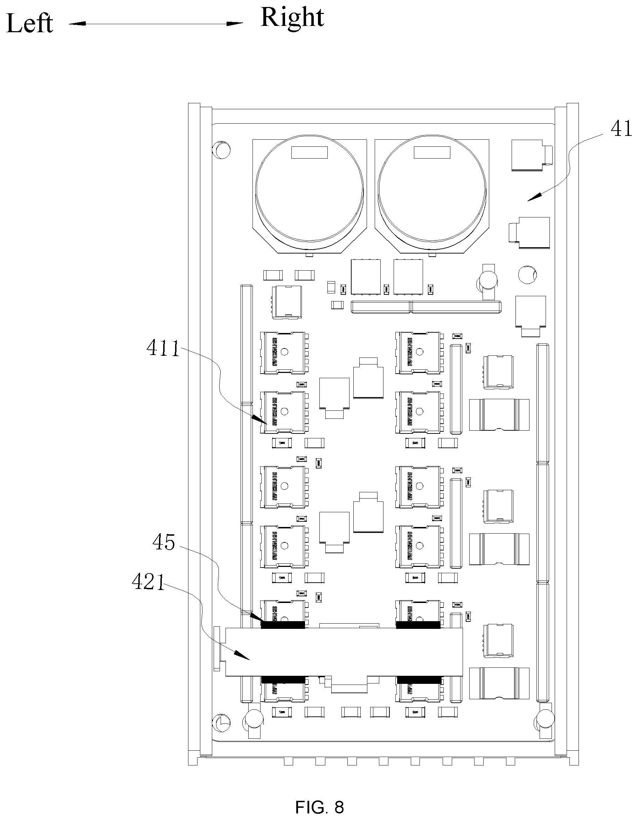

Optionally, as shown in FIG. 8, each power element group includes four power elements 411 (that is, four MOSFETs), and the four MOSFETs are symmetrically arranged in pairs in a left and right direction. In order that the main body 421 has the same thermal contact area with each MOSFET and achieves the same heat dissipation effect on each MOSFET, the part of the first connection portion 422 located below the main body 421 corresponds to the center position of the lower surface of the main body 421, and the first connection portion 422 is electrically connected at the center position among the four MOSFETs, that is, the center position of one power element group on the first circuit board 41. Thus, portions where two MOSFETs are in thermal contact with the main body 421 are on two sides of the first connection portion 422, respectively. As shown in FIGS. 6 and 7, the electrical connection between the first connection portion 422 and the first circuit board 41 is a plane with an area of greater than or equal to 25 mm². Optionally, the area of the first connection portion 422 may be 28 mm². Optionally, the area of the first connection portion 422 may be 30 mm². Optionally, the area of the first connection portion 422 may be 32 mm². Optionally, the area of the first connection portion 422 may be 35 mm². The contact area between the first connection portion 422 and the first circuit board 41 is increased through this plane, thereby enhancing the heat dissipation effect on the electrical connection between the first connection portion 422 and the first circuit board 41.

As shown in FIG. 7, the heat dissipation element 42 further includes a second connection portion 423. A first end of the second connection portion 423 is connected to the main body 421, and a second end of the second connection portion 423 is configured to be connected to a motor wire 631 of the electric motor 63. The length of the second connection portion 423 is greater than or equal to 5mm, and the width of the second connection portion 423 is greater than or equal to 8 mm. At least part of the second connection portion 423 is located above the main body 421, and the second connection portion 423 is connected to an edge of the main body 421. That is, the part of the second connection portion 423 and the part of the first connection portion 422 are located on the upper and lower sides of the main body 421, respectively. Specifically, the second connection portion 423 extends outward along a direction opposite to the first connection portion 422, that is, the second connection portion 423 extends upward. Optionally, the second connection portion 423 may extend outward toward the direction opposite to the first connection portion 421 along plane A perpendicular to the main body 421. Thus, the second connection portion 423 is within a projection area corresponding to the first circuit board 41, thereby avoiding an increase in the volume of the space in which the control assembly 40 is located. Additionally, the second connection portion 423 may extend outward toward a direction opposite to the first connection portion 421 along a direction having a certain angle to plane A.

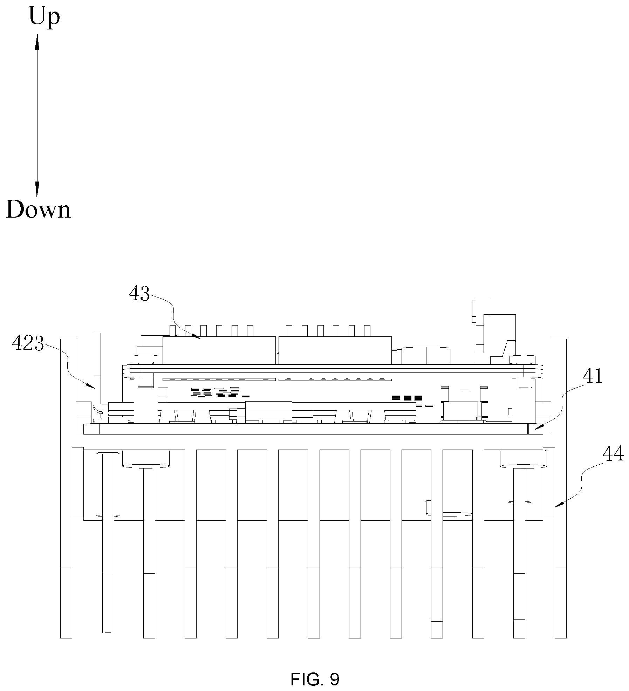

As shown in FIGS. 5 and 9, the control assembly 40 further includes the second circuit board 43, and the second circuit board 43 is located on the heat dissipation element 42 and in contact with the main body 421. The second circuit board 43 may be a control board and is connected to the first circuit board 41 to control drive signals of the power elements 411. As shown in FIG. 9, since the second connection portion 423 is connected to the edge of the main body 421, the second connection portion 423 is located on the side of the second circuit board 43. In addition, the second connection portion 423 is not in contact with the second circuit board 43. Thus, the second circuit board 43 does not interfere with the second connection portion 423 when the second connection portion 423 is connected to the motor wire 631 of the electric motor 63. Since three motor wires 631 of the motor 63 are provided, three heat dissipation elements 42 may also be provided. Thus, as shown in FIG. 3, each motor wire 631 is connected to one heat dissipation element 42. Furthermore, since the second connection portion 423 extends on the outer side of the second circuit board 43 instead of being located between the first circuit board 41 and the second circuit board 43, the height distance between the first circuit board 41 and the second circuit board 43 is reduced, thereby reducing the overall volume of the control assembly 40. In addition, since the second connection portion 423 extends on the outer side of the second circuit board 43 and does not need to pass through the second circuit board 43, the second circuit board 43 can maintain a complete function with a minimum area. Thus, the disadvantage is avoided that in the related art, the second connection portion 423 needs to pass through the second circuit board and occupies part of the area of the second circuit board 43, resulting in the necessity to increase the area of the second circuit board 43.

As shown in FIG. 4, the control assembly further includes a heat dissipation case 44. One surface of the heat dissipation case 44 is in contact with the first circuit board 41. That is, as shown in FIG. 9, the first circuit board 41, the second circuit board 43, and the heat dissipation elements 42 may all be disposed in the heat dissipation case 44. Multiple heat dissipation fins are provided on another surface of the heat dissipation case 44. Thus, the heat from the power elements 411 can be dissipated through both the heat dissipation elements 42 and the heat dissipation case 44, thereby further improving the heat dissipation effect on the power elements 411. The heat dissipation case 44 may be uncovered on two sides, as shown in FIG. 4 or may be covered on two sides, which is not limited in the present application.

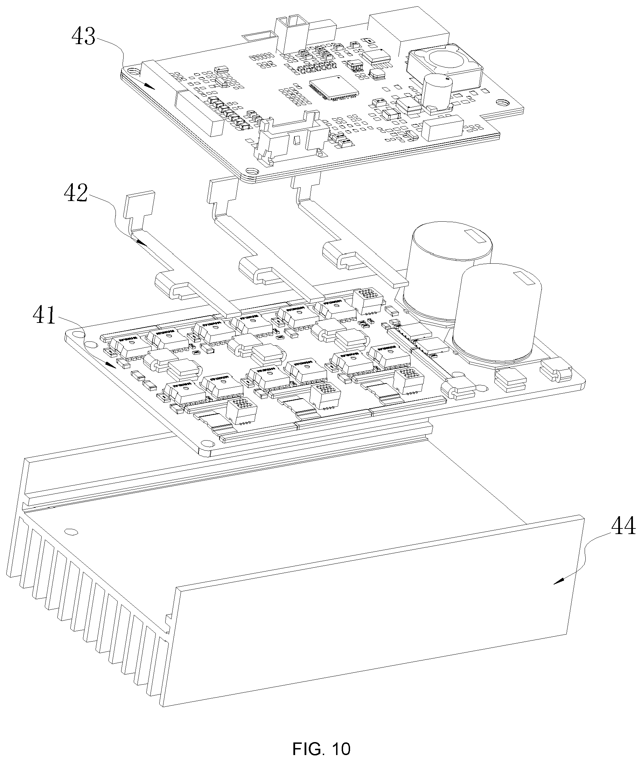

In some examples, the heat dissipation element 42 may have a first shape as shown in FIG. 5 or a second shape as shown in FIG. 10. The main body 421 of the heat dissipation element 42 in the second shape is narrower than the main body 421 of the heat dissipation element 42 in the first shape. Therefore, the heat dissipation element 42 in the first shape is applicable to a power tool with relatively high power while the heat dissipation element 42 in the second shape is applicable to a power tool with relatively low power. The main body 421 of the heat dissipation element 42 in the first shape has a length of greater than or equal to 24 mm and a width of greater than or equal to 8 mm, and the second connection portion 423 of the heat dissipation element 42 in the first shape has a length of greater than or equal to 5 mm and a width of greater than or equal to 8 mm. The main body 421 of the heat dissipation element 42 in the second shape has a length of greater than or equal to 24 mm and a width of greater than or equal to 4 mm, and the second connection portion 423 of the heat dissipation element 42 in the second shape has a length of greater than or equal to 5 mm and a width of greater than or equal to 4 mm.

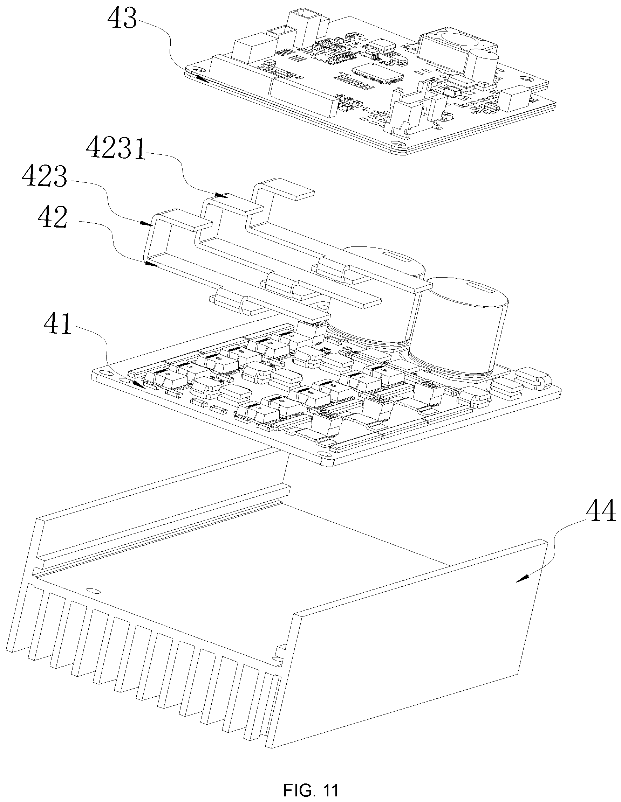

In some examples, the heat dissipation element 42 may have a third shape as shown in FIG. 11. The main body 421 of the heat dissipation element 42 in the third shape is wider than the main body 421 of the heat dissipation element 42 in the first shape. In addition, the second connection portion 423 not only extends outward along the direction opposite to the first connection portion 422 but also includes a bent portion 4231. Specifically, the bent portion 4231 means that the second connection portion 423 is bent inward on the upper side of the second circuit board 43 after extending beyond the second circuit board 43. Thus, the area of the second connection portion 423 is increased, thereby improving the heat dissipation effect of the heat dissipation element 42 in the third shape. The heat dissipation element 42 in the third shape is applicable to a power tool with relatively high power. The main body 421 of the heat dissipation element 42 in the third shape has a length of greater than or equal to 24 mm and a width of greater than or equal to 10 mm, and the second connection portion 423 of the heat dissipation element 42 in the third shape has a length of greater than or equal to 5 mm and a width of greater than or equal to 10 mm. In addition, a specific shape of the heat dissipation element 42 may be another shape and is not limited in the present application.

In some examples, the heat dissipation element 42 in the second shape is applicable to a power tool with power of greater than or equal to 1200 W or a power tool with a working current of greater than or equal to 20A, the heat dissipation element 42 in the first shape is applicable to a power tool with power of greater than or equal to 1800 W or a power tool with a working current of greater than or equal to 30 A, and the heat dissipation element 42 in the third shape is applicable to a power tool with power of greater than or equal to 3600 W or a power tool with a working current of greater than or equal to 60 A. In some examples, the heat dissipation element 42 in the second shape is also applicable to a power tool with power of greater than or equal to 1800 W or a power tool with a working current of greater than or equal to 30 A, the heat dissipation element 42 in the first shape is also applicable to a power tool with power of greater than or equal to 2700 W or a power tool with a working current of greater than or equal to 45 A, and the heat dissipation element 42 in the third shape is also applicable to a power tool with power of greater than or equal to 4500 W or a power tool with a working current of greater than or equal to 75 A.

In the present application, the multiple heat dissipation elements made of copper strips are used for dissipating the heat from the multiple power elements, and for each power element, one heat dissipation element is configured to be in thermal contact with the surface of the power element. Thus, the heat from the power element is simultaneously dissipated through the upper and lower surfaces of the heat dissipation element, thereby improving the heat dissipation effect of the heat dissipation element. In addition, the heat dissipation element is electrically connected to the first circuit board through the first connection portion of the heat dissipation element, thereby increasing the area of the electrical connection between the two and enhancing the heat dissipation effect on the electrical connection between the two. Moreover, the first connection portion that is electrically connected to the first circuit board and the main body that dissipates the heat from the power element are the different portions of the heat dissipation element. Thus, the heat transfer path between the main body and the power element can be shortened, thereby further improving the heat dissipation effect.

The basic principles, main features, and advantages of this application are shown and described above. It is to be understood by those skilled in the art that the aforementioned examples do not limit the present application in any form, and all technical solutions obtained through equivalent substitutions or equivalent transformations fall within the scope of the present application.

## Claims

1. A power tool, comprising:
a working assembly configured to perform work of the power tool;
a drive assembly comprising an electric motor and configured to drive the working assembly;
a power supply assembly configured to supply power to the drive assembly; and
a control assembly at least configured to control running of the electric motor;
wherein the control assembly comprises:
a first circuit board and at least one heat dissipation element;
wherein at least one power element is comprised on the first circuit board; and
each of the at least one heat dissipation element comprises:
a main body configured to be in thermal contact with a surface of a power element of the at least one power element; and
a first connection portion connected to the main body and electrically connected to the first circuit board.

2. The power tool according to claim 1, wherein the each of the at least one heat dissipation element further comprises a second connection portion, a first end of the second connection portion is connected to the main body, and a second end of the second connection portion is configured to be connected to a motor wire of the electric motor.

3. The power tool according to claim 2, wherein the second connection portion extends outward along a direction opposite to the first connection portion.

4. The power tool according to claim 2, wherein at least part of the first connection portion is located below the main body, and at least part of the second connection portion is located above the main body.

5. The power tool according to claim 1, wherein the main body is located on the power element and is in thermal contact with the surface of the power element through a thermally conductive adhesive.

6. The power tool according to claim 1, wherein the control assembly further comprises a second circuit board, and the second circuit board is located on the each of the at least one heat dissipation element and in contact with the main body.

7. The power tool according to claim 1, wherein the each of the at least one heat dissipation element further comprises a second connection portion, the control assembly further comprises a second circuit board, and the second connection portion is located on a side of the second circuit board.

8. The power tool according to claim 1, wherein the control assembly further comprises a heat dissipation case, one surface of the heat dissipation case is in contact with the first circuit board, and a plurality of heat dissipation fins are provided on another surface of the heat dissipation case.

9. The power tool according to claim 1, wherein the each of the at least one heat dissipation element is made of copper.

10. The power tool according to claim 1, wherein the power element is a metal-oxide-semiconductor field-effect transistor (MOSFET).

11. The power tool according to claim 10, comprising a plurality of power elements, every preset number of power elements among the plurality of power elements are defined as one power element group, a number of the at least one heat dissipation element is equal to a number of power element groups, and each heat dissipation element corresponds to one power element group.

12. The power tool according to claim 11, wherein the each of the at least one heat dissipation element is electrically connected at a central position of corresponding one power element group.

13. The power tool according to claim 1, wherein the first connection portion is a plane with an area of greater than or equal to 25 mm².

14. The power tool according to claim 1, wherein power of the power tool is greater than or equal to 1200 W.

15. The power tool according to claim 1, wherein a working current of the power tool is greater than or equal to 20 A.

16. A power tool, comprising:
a working assembly configured to perform work of the power tool;
a drive assembly comprising an electric motor and configured to drive the working assembly;
a power supply assembly configured to supply power to the drive assembly; and
a control assembly at least configured to control running of the electric motor;
wherein the control assembly comprises:
a first circuit board, at least one heat dissipation element, and a heat dissipation case;
wherein one surface of the first circuit board is electrically connected to the at least one heat dissipation element, and the other surface of the first circuit board is in contact with the heat dissipation case.

17. The power tool according to claim 16, wherein at least one power element is comprised on the first circuit board, each of the at least one heat dissipation element comprises a first connection portion and a main body, and the main body is in thermal contact with a surface of a power element of the at least one power element when the first connection portion is electrically connected to the first circuit board.

18. The power tool according to claim 17, wherein the each of the at least one heat dissipation element further comprises a second connection portion, a first end of the second connection portion is connected to the main body, and a second end of the second connection portion is configured to be connected to a motor wire of the electric motor.

19. A power tool, comprising:
a working assembly configured to perform work of the power tool;
a drive assembly comprising an electric motor and configured to drive the working assembly;
a power supply assembly configured to supply power to the drive assembly; and
a control assembly at least configured to control running of the electric motor;
wherein the control assembly comprises:
a first circuit board and at least one heat dissipation element;
wherein each of the at least one heat dissipation element comprises a first connection portion, a main body, and a second connection portion, and the first connection portion and the second connection portion are each connected to the main body; and
the first connection portion is configured to be electrically connected to the first circuit board, and the second connection portion is configured to be connected to a motor wire of the electric motor, wherein the first connection portion and the second connection portion extend in opposite directions along a direction perpendicular to the main body.

20. The power tool according to claim 19, wherein at least one power element is comprised on the first circuit board, and the main body is in thermal contact with a surface of a power element of the at least one power element.
